# FASCICULE DE BREVET EUROPEEN

(11) **EP 0 351 268 B1**
(45) Date de publication et mention de la délivrance du brevet: **21.04.1993**
(21) Numéro de dépôt: 89401786.2
(22) Date de dépôt: 23.06.1989
(51) Int. Cl.: H01R 43/02, B23K 1/20

(54) **Procédé de soudure des fils de connexions extérieures sur un composant électronique**
Verfahren zum Löten von äusseren Verbindungsdrähten auf einem elektronischen Bauteil
Process for soldering exterior connecting wires to an electronic component

(30) Priorité: 13.07.1988 FR 8809546
(43) Date de publication de la demande: 17.01.1990
(73) Titulaire: COMPAGNIE EUROPEENNE DE COMPOSANTS ELECTRONIQUES LCC, F-92400 Courbevoie (FR)
(72) Inventeur: Mentzer, Régis, F-92402 Courbevoie Cédex (FR); Henry, Michel, F-92402 Courbevoie Cédex (FR)
(74) Mandataire: Taboureau, James

(56) Documents cités:
- DE-A- 1 665 608
- GB-A- 1 425 595
- US-A- 3 886 650

## Description

La présente invention concerne un procédé de soudure des fils de sorties sur les composants en électronique. Elle comprend également un composant muni d'au moins une connexion extérieure par fil métallique soudé par le procédé de l'invention.

De nombreux composants ont leurs connexions extérieures réalisées au moyen de fils métalliques, généralement en cuivre d'un diamètre de l'ordre de 0,6 à 0,8 mm. Ces fils servent dans un premier temps à manipuler le composant, puis dans un deuxième temps à le fixer sur un substrat ou circuit, fonctions secondaires par rapport à leur fonction principale qui est l'accès électrique au composant.

La fixation de ces fils doit donc être mécaniquement forte, de bonne ohmicité, et simultanément commode pour le procédé d'assemblage et économique.

Parmi les procédés connus, sont essentiellement utilisés, à l'échelle industrielle :
- la soudure au trempé, en bain mort ou la vague,
- la soudure par refusion soit d'une crème à souder, soit d'un surplus d'étamage apporté sur les fils de connexions.

La soudure au trempé ne donne pas d'excellents rendements industriels, parce que le composant, soumis à la poussée d'Archimède lorsqu'il est trempé dans le bain de soudure fondue, se déplace par rapport à ses fus de connexions.

La soudure par crème à souder est côuteuse. Enfin, la soudure par refusion d'un surplus d'étamage sur les fils est imprécise : lorsque l'étamage des fils fond, le composant est mal tenu en place, puisqu'un film liquide sépare le composant du fil de connexion.

L'invention permet de supprimer ces inconvénients et de faciliter la soudure des fils sur un composant, avec une soudure parfaitement localisée, à faible prix, et un composant bien positionné. Le procédé selon l'invention consiste à munir l'extrêmité d'un fil de connexion à souder sur un composant d'une préforme de soudure, cette préforme n'entourant pas complètement le fil de sorte que celui-ci puisse être en contact direct avec le composant sur lequel il s'appuie. Le fil est préalablement déformé localement, pour supprimer son axe de symétrie et empêcher la rotation de la préforme de soudure autour du fil. La soudure sur le composant du fil ainsi garni se fait par refusion.

De façon plus précise, l'invention concerne un procédé de soudure des fils de connexions extérieures sur un composant électronique muni de surfaces soudables, caractérisé par la suite des opérations suivantes :
a) au moins un fil de connexion est matricé à son extrêmité à souder pour lui communiquer une dissymétrie de révolution,
b) un ruban de soudure est serti sur l'extrêmité déformée du fil, avec déformation dudit ruban de façon à en faire une préforme de soudure qui laisse apparente une partie de la surface de l'extrêmité du fil
c) le composant à souder est présenté contre le fil muni de sa préforme de soudure, la surface soudable du composant étant en face de la partie de l'extrêmité du fil qui n'est pas enrobée par la préforme de soudure
d) fluxage et soudure par refusion.

L'invention sera mieux comprise par l'explication plus détaillée qui suit maintenant d'un exemple d'application, s'appuyant sur les figure jointes en annexe, toutes relatives à l'invention, qui représentent :
- figure 1 : vue de trois - quarts dans l'espace d'une bande de fils de connexions
- figure 2 : vues détaillées, en coupe et en plan, d'un fil de connexion déformé,
- figure 3 : vues détaillées, en coupe et en plan, d'un fil de connexion muni d'une préforme de soudure,
- figures 4 à 6 : vues schématisées, en coupe, de l'outil et du procédé d'enroulement d'une préforme de soudure sur un fil de connexion.

De façon à être plus claire et précise, l'invention sera exposée en s'appuyant sur le cas d'un condensateur céramique de forme disque, ce qui ne limite pas la portée du procédé applicable à la soudure de tout fil de connexion extérieure sur un composant.

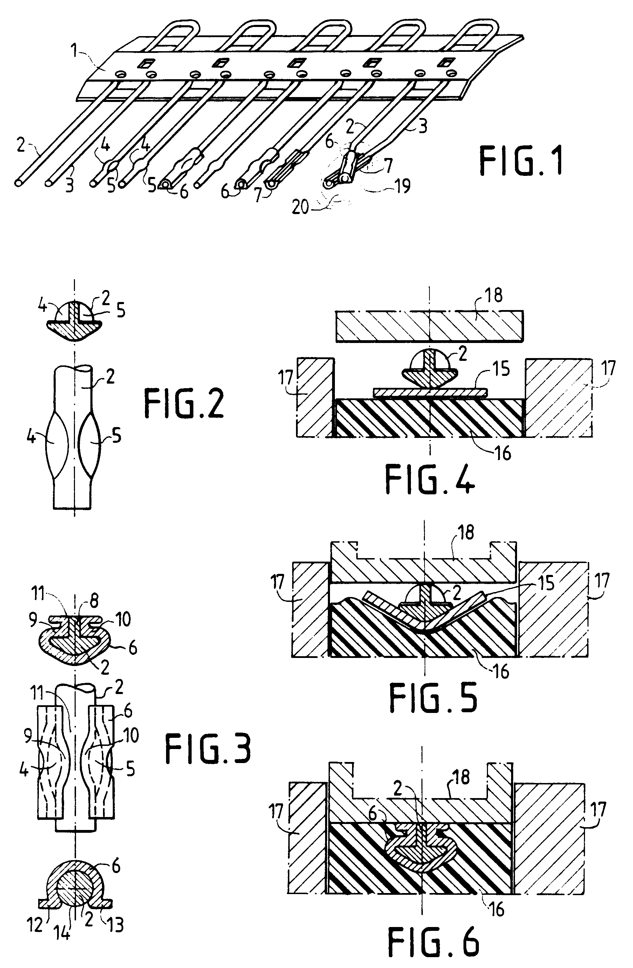

Il est connu que les condensateurs disques céramiques sont fabriqués par des procédés industriels collectifs : la figure 1 représente un élément de bande de condensateurs, avec pour chaque paire de fils les différentes étapes du procédé de soudure.

Une bande de carton 1, convenablement perforée, supporte une pluralité d'épingles de fil métallique, typiquement en cuivre d'un diamètre de l'ordre de 0,5 mm, rigide, de sorte que deux fils de connexions 2 et 3 se présentent, parallèles, sur un côté de la barrette. Ces fils sont très généralement de section ronde.

La première étape du procédé consiste à matricer ces fils, de façon à les déformer pour leur faire perdre leur symétrie de révolution, sur l'extrêmité qui recevra une préforme de soudure. Ce matriçage empêche la préforme de tourner autour du fil, et lui impose une position déterminée.

La figure 2 donne le détail agrandi de l'extrémité matricée du fil 2. Dans l'exemple représenté, le fil a été matricé au moyen de deux poinçons cylindriques qui ont laissé des empreintes 4 et 5, mais le fil pourrait également comporter un aplatissement local, en spatule, ou une série de morsures qui lui font perdre sa symétire de révolution. Cependant, on verra plus loin les raisons qui font que cette forme de matriçage est avantageuse.

Le matriçage des fils de connexions 2 et 3 se fait selon une direction bien déterminée. Par exemple, pour un condensateur disque à deux connexions de sorties, un premier fil 2 est matricé par dessus le plan défini par la barrette 1 et la nappe de fils 2-3, et un second fil 3 est matricé par dessous ce même plan, de sorte que les deux matriçages se font face, et participeront ultérieurement à une pince qui maintiendra en place le composant, pendant la refusion.

Chacun des fils de connexions 2 et 3 est ensuite muni d'une préforme de soudure 6 et 7, qui enrobe partiellement le fil de cuivre, mais laisse dégagée une génératrice de ce fil.

La forme de cette préforme de soudure est détaillée en figure 3. Le fil de cuivre 2 est serti dans une gaine de soudure 6, qui ne peut ni glisser le long du fil, ni tourner autour de lui, en raison des empreintes 4 et 5 de matriçage. Entre les empreintes demeure une partie 8 non déformée du fil 2, et la préforme pénètre, par déformation, dans les empreintes 4 et 5, et vient enserrer en 9 et 10 la partie non déformée 8 du fil, sans toutefois déborder sur la surface extérieure 11 de ladite partie 8.

La préforme de soudure 6 a une longueur plus grande que celle de la zone du fil 2 déformée par les empreintes 4 et 5, de sorte que, dans la partie du fil extérieure aux empreintes, la préforme 6 a une section en oméga, avec deux ailettes 12 et 13 qui sont dans le plan d'une génératrice 14 du fil 2 : cette génératrice 14 est elle-même confondue avec le plan extérieur 11 de la partie non déformée 8 du fil 2.

On voit donc que la préforme de soudure 6 laisse apparente une partie de la surface du fil 2 : c'est par cette partie que le fil s'appuie sur le composant et le maintient. Au cours de la refusion de la soudure, le composant sera toujours en contact avec le fil de connexion, et il n'y aura pas de film liquide de soudure entre le composant et le fil, comme c'est le cas avec les connexions préétamées.

Il a été dit que les matriçages sur les fils 2 et 3 se font dans deux directions opposées : par conséquent, la préforme 6 sur le fil 2 et la préforme 7 sur le fil 3 laissent apparentes deux parties opposées des fils 2 et 3, qui enserreront le disque du condensateur par ses deux faces principales.

La pose d'une préforme de soudure 6 sur un fil matricé 2 se fait très simplement, et est expliquée par les figures 4 à 6.

Un morceau 15 de ruban de soudure est posé sur une matrice 16 en matériau déformable et élastique, tel qu'un bloc de polyuréthane par exemple, maintenu dans une machoire 17. L'extrêmité matricée du fil 2 est posée sur ce morceau de ruban 15, bien symétrique par rapport à son axe longitudinal. Un poinçon métallique 18, de préférence guidé par la machoire 17, enfonce le fil 2 dans la matrice 16, laquelle impose au ruban 15 de fluer autour du fil : lorsque le poinçon 18 est relevé, le fil 2 est garni d'une préforme de soudure 6, qui épouse en 9 et 10 les empreintes 4 et 5 du fil, et qui forme en 12 et 13 deux ailes qui, par l'action du poinçon 18 sont dans le plan de la surface 14 du fil non matricé.

Cette opération, très simple, nécessite seulement que le morceau de ruban 15 ait une épaisseur, de l'ordre de 0,2 mm, faible par rapport à sa largeur, ce qui permet sa déformation montrée en figures 5 et 6. La largeur du ruban 15 est de l'ordre de la circonférence du fil 2. Plus le diamètre du fil est petit plus on choisit une épaisseur faible du ruban de soudure.

La suite des opérations reprend des techniques connues. En figure 1, un composant 19, tel qu'un disque de condensateur céramique muni sur chaque face d'une métallisation soudable 20, est introduit entre les deux extrêmités, préalablement pliées, des fils 2 et 3, munis de leurs préformes de soudure 6 et 7. Le composant y est représenté en pointillés pour laisser voir les fils de connexions.

L'ensemble est enduit de flux, par exemple par trempage dans un bain moussant de flux, puis soudé par refusion par passage dans un four continu, de préférence vertical pour assurer la régularité des soudures sur les deux faces.

La forme des empreintes 4 et 5 et celle des ailettes 12 et 13 de la préforme 6 font que, pendant la soudure, le composant est, à tout moment, bien tenu par les surfaces 11 et 14 de chacun des deux fils.

Le procédé de soudure selon l'invention jouit de plusieurs avantages :
- le dépôt de la soudure est parfaitement localisé.
- la quantité de soudure est bien maitrisée.
- le fluxage est séparé de l'opération de soudure, par conséquent on peut jouer indépendamment sur la nature du flux et celui de la soudure.
- le côut de revient de la soudure est minimum.
- pendant la phase de fusion de la soudure, le disque ne subit pas de contraintes mécaniques extérieures. Son centrage entre les fils reste correct.
- le procédé se prête à l'automatisation.

## Revendications

1. Procédé de soudure des fils de connexions extérieures sur un composant électronique (19) muni de surfaces soudables (20), caractérisé par la suite des opérations suivantes :
a) au moins un fil de connexion (2) est matricé à son extrêmité à souder pour lui communiquer une dissymétrie de révolution,
b) un ruban de soudure (15) est serti sur l'extrêmité déformée du fil (2), avec déformation dudit ruban (15) de façon à en faire une préforme de soudure (6) qui laisse apparente une partie (11,14) de la surface de l'extrêmité du fil (2),
c) le composant à souder (19) est présenté contre le fil (2) muni de sa préforme de soudure (6), la surface soudable (20) du composant (19) étant en face de la partie (11,14) de l'extrêmité du fil (2) qui n'est pas enrobée par la préforme de soudure (6),
d) fluxage et soudure par refusion.

2. Procédé de soudure selon la revendication 1 caractérisé en ce que le matriçage de l'extrêmité à souder d'au moins un fil de connexion (2) est effectué de manière à ce qu'il permette de positionner la préforme de soudure (6) avec précision, sans rotation autour du fil ni glissement le long du fil, et de préserver une surface (11,14) d'appui direct du fil (2) sur le composant (19) à souder.

3. Procédé de soudure selon la revendication 1, caractérisé en ce que le sertissage d'une préforme de soudure (6) sur un fil de connexion (2) comprend les opérations suivantes :
a) sur une matrice (16) en matériau déformable et élastique, dépose d'un morceau de ruban (15) de soudure, de largeur sensiblement égale à la circonférence du fil (2), et d'épaisseur faible devant la largeur,
b) dépose de l'extrémité matricée du fil de connexion (2) sur le ruban de soudure (15), selon son axe de symétrie,
c) déformation du ruban (15) au moyen d'un poinçon (18) qui, appuyant sur le fil (2), imprime le ruban (15) dans la matrice déformable (16), laquelle fait fluer le ruban (15) contre les empreintes (4,5) de matriçage du fil (2) et forme une préforme de soudure (6), la surface (11,14) du fil (2) en contact avec le poinçon (18) restant dégagée de métal de soudure.

## Patentansprüche

1. Verfahren zum Anlöten der äußeren Anschlußdrähte an ein elektronisches Bauelement (19), das lötfähige Oberflächen (20) besitzt, gekennzeichnet durch den Ablauf der folgenden Verfahrensschritte:
a) mindestens ein Anschlußdraht (2) wird an dem anzulötenden Ende geprägt, so daß er seine drehsymmetrische Form verliert,
b) ein Lötmetallband (15) wird auf das verformte Ende des Drahts (2) aufgepreßt, wobei das Band (15) so verformt wird, daß es einen Lötmetall-Rohling (6) bildet, der einen Bereich (11, 14) der Oberfläche am Ende des Drahtes (2) freiläßt,
c) das anzulötende Bauelement (19) wird gegen den Draht (2) und seinen Lötmetall-Rohling (6) gehalten, wobei die lötfähige Oberfläche (20) des Bauelements (19) dem Bereich (11, 14) des Endes des Drahts (2) gegenüberliegt, der nicht von dem Lötmetall-Rohling (6) umgeben ist,
d) dann folgen die Flußmittelbenetzung und das Verlöten durch Schmelzen des Rohlings.

2. Lötverfahren nach Anspruch 1, dadurch gekennzeichnet, daß das Prägen des anzulötenden Endes mindestens eines Anschlußdrahts (2) so geschieht, daß der Lötmetall-Rohling (6) genau und ohne Drehung um den Draht und ohne Verrutschen entlang des Drahts positioniert werden kann, wobei ein Oberflächenbereich (11, 14) verbleibt, über den der Draht (2) direkt auf dem anzulötenden Bauelement (19) aufliegt.

3. Lötverfahren nach Anspruch 1, dadurch gekennzeichnet, daß das Aufpressen eines Lötmetall-Rohlings (6) auf einen Anschlußdraht (2) folgende Verfahrensschritte enthält:
a) auf einer Matrix (16) aus verformbarem und elastischem Material wird ein Stück eines Lötmetallbandes (15) mit einer Breite von im wesentlichen gleich dem Umfang des Drahtes (2) und einer demgegenüber geringen Dicke aufgelegt,
b) das geprägte Ende des Anschlußdrahts (2) wird auf das Lötmetallband (15) gemäß seiner Symmetrieachse aufgelegt,
c) das Band (15) wird mit Hilfe eines Stempels (18) verformt, der durch Druck auf den Draht (2) das Band (15) in die verformbare Matrix (16) hineindrückt, die ihrerseits das Band (15) eng an die Prägespuren (4, 5) des Drahts (2) andrückt und einen Lötmetall-Rohling (6) bildet, wobei die mit dem Stempel (18) in Kontakt stehende Oberfläche (11, 14) des Drahts (2) von Lötmetall frei bleibt.

## Claims

1. A method for soldering outside connection wires onto an electronic component (19) provided with surfaces adapted to be soldered (20), characterized by the following sequence of operations:
a) at least one connection wire (2) is stamped at its end to be soldered in order to lose its axial symmetry,
b) a strip (15) of soldering metal is applied to the stamped end of the wire (2), whereby said strip (15) is deformed and becomes a soldering slug (6) which leaves free a portion (11, 14) of the surface at the end of the wire (2),
c) the component to be soldered (19) is positioned in face of the wire (2) bearing its soldering slug (6), the soldering surface (20) of the component (19) facing the portion (11, 14) of the end of the wire (2) which is not covered by the soldering slug (6),
d) application of flux material and soldering by fusion.

2. A soldering method according to claim 1, characterized in that the end of at least one connection wire (2) intended to be soldered is stamped in such a way that it allows to position exactly the soldering slug (6) without any rotation about the wire and slipping along the wire while allowing a surface (11, 14) of the wire exempt of soldering material to be directly applied to the component (19) to be soldered.

3. A soldering method according to claim 1, characterized in that applying a soldering slug (6) on a connection wire (2) includes the following operations:
a) a piece of soldering strip (15) having a width substantially equal to the circumference of the wire (2) and a thickness which is small compared to its width, is deposited on a deformable and resilient matrix (16),
b) the stamped end of the connection wire (2) is deposited along its axis of symmetry on the soldering strip (15),
c) the strip (15) is deformed by means of a stamp (18) which is applied on the wire (2) and urges the strip (15) into the deformable matrix (16) which makes the strip (15) fit snugly into the stamping notches (4, 5) of the wire and forms a soldering slug (6), the surface (11, 14) of the wire in contact with the stamp (18) remaining free of soldering metal.
